# EUROPEAN PATENT APPLICATION

(11) **EP 2 860 780 A1**
(43) Date of publication of application: **15.04.2015**
(21) Application number: 14178578.2
(22) Date of filing: 25.07.2014
(51) Int. Cl.: H01L 37/00

(54) **Thermoelectric converting thin line, and thermoelectric converting cloth formed using the same**

(30) Priority: 08.10.2013 JP 2013211462
(71) Applicant: Kabushiki Kaisha Toshiba, Tokyo (JP)
(72) Inventor: Yuasa, Hiromi, Tokyo (JP); Kado, Masaki, Tokyo (JP); Kamiguchi, Yuuzo, Tokyo (JP)
(74) Representative: Granleese, Rhian Jane

(57) **Abstract**

A thermoelectric converting thin line includes a thin line extending in one direction, a first ferromagnetic layer formed on a side of the thin line having a magnetization fixed in a plane in a direction intersecting with a direction along which the thin line extends, and a first nonmagnetic metal layer formed on the first ferromagnetic layer.

## Description

### CROSS-REFERENCE TO RELATED APPLICATION

This application is based upon and claims the benefit of priority from Japanese Patent Application No. 2013-211462, filed October 8, 2013; the entire contents of which are incorporated herein by reference.

### FIELD

Embodiments described herein relate to a thermoelectric converting thin line, and a thermoelectric converting cloth.

### BACKGROUND

As one of thermoelectric converting elements, there has been known a thermoelectric converting element using a spin Seebeck effect. However, the thermoelectric converting element which uses a spin Seebeck effect exhibits low power generation efficiency.

### DESCRIPTION OF THE DRAWINGS

Fig. 1A is a schematic view illustrating a thermoelectric converting thin line according to a first embodiment.
Fig. 1B is a cross-sectional view taken along a line A-A' illustrating the thermoelectric converting thin line according to the first embodiment.
Fig. 2A is a view for illustrating a thermoelectric converting thin line according to a second embodiment.
Fig. 2B is a cross-sectional view taken along a line A-A' illustrating the thermoelectric converting thin line according to the second embodiment.
Fig. 3 is a view illustrating a result of measurement of an electromotive force.
Fig. 4A is a view for illustrating a thermoelectric converting thin line according to a third embodiment.
Fig. 4B is a cross-sectional view taken along a line A-A' showing the thermoelectric converting thin line according to the third embodiment.
Fig. 5A is a view for illustrating a thermoelectric converting thin line according to a fourth embodiment.
Fig. 5B is a cross-sectional view taken along a line A-A' showing the thermoelectric converting thin line according to the fourth embodiment.
Fig. 6A is a view for illustrating a thermoelectric converting thin line according to a fifth embodiment.
Fig. 6B is a cross-sectional view taken along a line A-A' showing the thermoelectric converting thin line according to the fifth embodiment.
Fig. 7 is a view illustrating a thermoelectric converting cloth which may be manufactured using any one of the above-mentioned embodiments.
Fig. 8 is a view illustrating another thermoelectric converting cloth which may be manufactured using any one of the above-mentioned embodiments.
Fig. 9 is a view illustrating still another thermoelectric converting cloth which may be manufactured using any one of the above-mentioned embodiments.
Fig. 10 is a view illustrating the constitution of the thermoelectric converting cloth shown in Fig. 9.
Fig. 11 is a view illustrating a method of manufacturing a thermoelectric converting thin line.
Fig. 12 is a view illustrating another method of manufacturing a thermoelectric converting thin line.

### DETAILED DESCRIPTION

According to an embodiment, there are provided a thermoelectric converting thin line having high flexibility and a thermoelectric converting cloth having high power generation efficiency.

In general, according to one embodiment, a thermoelectric converting thin line includes a thin line that extends in one direction, a first ferromagnetic layer that is formed on the thin line and has a magnetization fixed in a plane in a direction intersecting with a direction along which the thin line extends, and a first nonmagnetic metal layer that is formed on the ferromagnetic layer.

Respective exemplary embodiments are explained by reference to drawings hereinafter. Parts to which the same symbol is given indicate the same parts. A thermoelectric converting thin line and a thermoelectric converting cloth are schematically or conceptually illustrated in the drawings and hence, the relationship between thicknesses and widths of respective parts, a ratio coefficient between sizes of the respective parts and the like are not limited to those of a thermoelectric converting thin line and a thermoelectric converting cloth which are actually manufactured. Further, even when the same part is illustrated in the plurality of drawings, there may be a case where the size of the part or a ratio coefficient between sizes of parts in one drawing differs from the size of the part in other drawings according to the drawing.

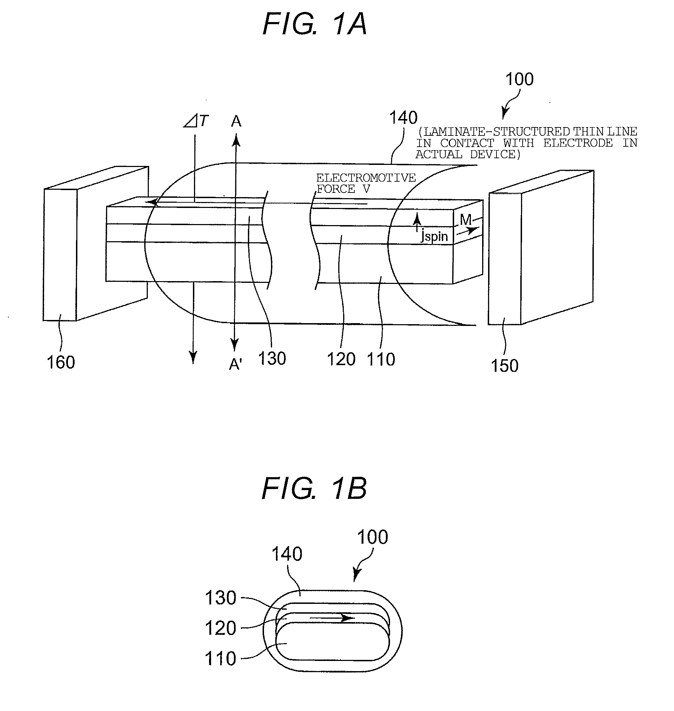

Fig. 1A and Fig. 1B are views illustrating a thermoelectric converting thin line 100. Fig. 1A is a perspective view of the thermoelectric converting thin line 100. Fig. 1B is a cross-sectional view taken along a line A-A' in the perspective view illustrating the thermoelectric converting thin line 100.

The thermoelectric converting thin line 100 includes: a thin line 110; a ferromagnetic layer 120 that is formed on the thin line 110; a nonmagnetic metal layer 130 that is formed on the ferromagnetic layer 120; and a nonmagnetic insulating film 140 that surrounds a laminate-structured thin line including the thin line 110, the ferromagnetic layer 120 and the nonmagnetic metal layer 130. The ferromagnetic layer 120 generates a spin current, thus serving as a spin current generating layer. The nonmagnetic metal layer 130 serves as a spin current detection layer which detects a spin current generated in the ferromagnetic layer 120. As shown in Fig. 1B, the thermoelectric converting thin line 100 extends in one direction. Electrodes 150, 160 are respectively connected to both ends of the thermoelectric converting thin line 100 in the extending direction of the thermoelectric converting thin line 100. That is, the electrodes 150, 160 are respectively connected to both ends of the laminate-structured thin line.

The thin line 110 may preferably be formed of a nonmagnetic insulating material. Polyimide, polypropylene, nylon, polyester, Parylene (registered trademark), rubber, biaxially stretched polyethylene 2, 6-naphthalate or modified polyamide may be used as the nonmagnetic insulating material. The thin line 110 may be formed by laminating the materials. With respect to a shape of the thin line 110, it is preferable that the thin line 110 has a flat cross section in the direction intersecting with the extending direction of the thin line 110. An aspect ratio of the cross section of the thin line 110 in the direction intersecting with the extending direction of the thin line 110 is preferably set such that a ratio between a size in a short-axis direction and a size in a long-axis direction is set to approximately 1 to 2. By making the cross section of the thin line 110 in the direction intersecting with the extending direction of the thin line 110 be relatively flat, a film may be easily formed on the thin line 110.

The ferromagnetic layer 120 has a fixed magnetization in an in-plane direction of the ferromagnetic layer 120. That is, the magnetization of the ferromagnetic layer 120 is fixed in the direction intersecting with the extending direction of the thin line 110 (the short direction of the thin line 110). The ferromagnetic layer 120 may be formed of a metallic ferromagnetic material, an insulating ferromagnetic material or garnet. Fe, Co, Ni, FeCr, FeMn, FeCo, NiFe or CoNi may be used as the metallic ferromagnetic material. Ferrite may be used as the insulating ferromagnetic material. Y₃Fe₅O₁₂ may be used as garnet. A laminated body which is formed by laminating the metallic ferromagnetic material, the insulating ferromagnetic material, ferrite and garnet may be used as the ferromagnetic layer 120. For example, as a laminate structure, it is possible to use a laminate structure where a Pt layer having a thickness of 5nm is laminated on a Y₃Fe₅O₁₂ layer, or a laminate structure where a FeCr layer having a thickness of 0.15nm is laminated on a Y₃Fe₅O₁₂ layer and a Pt layer having a thickness of 5nm is laminated on the FeCr layer. A spin Seebeck coefficient is 127 µV/Km in the former laminate structure, and a spin Seebeck coefficient is 150 µV/Km in the latter laminate structure. The laminate structures are merely examples, and an output may be increased by adjusting elements and thicknesses of the layers.

The nonmagnetic metal layer 130 may be formed of Pt, Au, Ir, Ta, W or Cr. Pt, Au and Ir are defined as materials which belong to a group A, and Ta, W and Cr are defined as materials which belong to a group B. The materials which belong to the group A differ from the materials which belong to the group B in polarity when a spin current is converted into an electric current. That is, when the material which belongs to the group A generates a positive electromotive force, the material which belongs to the group B generates a negative electromotive force. The reason is considered that a spin Hall angle of the material which belongs to the group A and a spin Hall angle of the material which belongs to the group B have polarities diametrically opposite to each other. In the thermoelectric converting thin line 100, the nonmagnetic metal layer 130 may be formed of either one of the material which belongs to the group A or the material which belongs to the group B.

The nonmagnetic insulating film 140 is provided for preventing short-circuiting between the plurality of thermoelectric converting thin lines 100 which are arranged adjacent to each other. When the thermoelectric converting thin line 100 is connected to an external line, the nonmagnetic insulating film 140 may also prevent short-circuiting between the thermoelectric converting thin line 100 and the external line. The nonmagnetic insulating film 140 may be formed of polyimide, polypropylene, nylon, polyester, Parylene (registered trademark), rubber, biaxially stretched polyethylene 2, 6-naphthalate or modified polyamide.

The electrodes 150, 160 may be formed of Cu.

The operation principle of the thermoelectric converting thin line 100 is described. The thermoelectric converting thin line 100 may generate power by using a spin Seebeck effect.

When a temperature gradient ΔT is given to the thin line 110, the ferromagnetic layer 120 and the nonmagnetic metal layer 130, a difference is generated between the distribution of up-spin electrons in the ferromagnetic layer 120 and the distribution of down-spin electrons in the ferromagnetic layer 120. This phenomenon is referred to as a spin Seebeck effect. The difference between the distribution of up-spin electrons and the distribution of down-spin electrons generated in the phenomenon is referred to as a spin pressure.

A spin pressure generated in the ferromagnetic layer 120 propagates to the nonmagnetic metal layer 130 as a spin current. The spin current is a flow which is generated by the difference between the distribution of up-spin electrons and the distribution of down-spin electrons. The spin current is not a flow of a charge. When the spin current propagates in the nonmagnetic metal layer 130, a charge (electric current) flows in the direction orthogonal to the spin current and the magnetization of the ferromagnetic layer 120 by inverse spin Hall effect, thus an electromotive force is generated. Accordingly, an electromotive force is generated in the direction along which the thermoelectric converting thin line 100 extends.

To generate power more efficiently, the ferromagnetic layer 120 and the nonmagnetic metal layer 130 are brought into contact with each other. This is because a spin current generated in the ferromagnetic layer 120 efficiently propagates to the nonmagnetic metal layer 130 in such a constitution.

The direction of an electromotive force differs between the case where the material which belongs to the group A is used for forming the nonmagnetic metal layer 130 and the case where the material which belongs to the group B is used for forming the nonmagnetic metal layer 130.

Because the thermoelectric converting thin line 100 is in the form of threads, the thermoelectric converting thin line 100 has flexibility. Accordingly, the thermoelectric converting thin line 100 may be wound around a heating element without forming a gap therebetween, thus power may be generated efficiently. Further, because the thermoelectric converting thin line 100 is in the form of threads, the thermoelectric converting thin line 100 may be handled with ease. Accordingly, by weaving the thermoelectric converting thin lines 100 into a cloth, the thermoelectric converting thin lines 100 may be easily mounted, thus an amount of power may be enhanced.

The thermoelectric converting thin line has an elliptical cross section or a flat cross section, and a width of the thermoelectric converting thin line in the longitudinal direction is 50 µm to 1 mm.

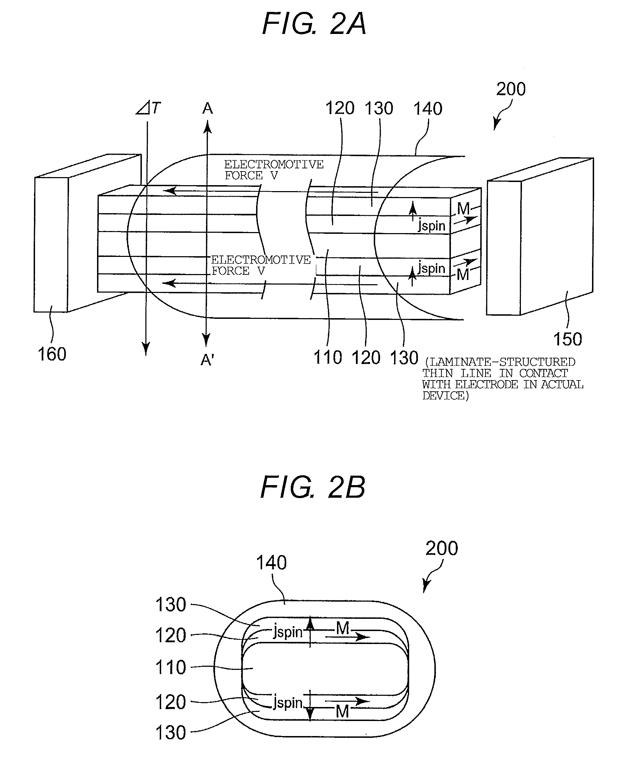

Fig. 2A and Fig. 2B are views illustrating a thermoelectric converting thin line 200 according to a second embodiment. Fig. 2A is a perspective view of the thermoelectric converting thin line 200. Fig. 2B is a cross-sectional view taken along a line A-A' in the perspective view of the thermoelectric converting thin line 200.

In the thermoelectric converting thin line 200, a ferromagnetic layer 120 and a nonmagnetic metal layer 130 are formed on an upper surface and a lower surface of the thin line 110, respectively. That is, two ferromagnetic layers 120 and two nonmagnetic metal layers 130 are formed on the thin line 110. A laminate-structured thin line formed of the thin line 110, the two ferromagnetic layers 120 and the two nonmagnetic metal layers 130 is surrounded by a nonmagnetic insulating film 140. Electrodes 150, 160 are respectively connected to both ends of the thermoelectric converting thin line 200 (laminate-structured thin line) in the extending direction of the thermoelectric converting thin line 200.

The magnetization of the ferromagnetic layer 120 is fixed in the in-plane direction of the ferromagnetic layer 120. That is, the magnetization of the ferromagnetic layer 120 is fixed in the direction intersecting with the direction along which the thin line 110 (the short direction of the thin line 110) extends. The magnetizations of the two ferromagnetic layers 120 are parallel to each other and are directed in the same direction. In the thermoelectric converting thin line 200, a direction of an electromotive force generated in one nonmagnetic metal layer 130 is the same as a direction of an electromotive force generated in the other nonmagnetic metal layer 130.

In the thermoelectric converting thin line 200, the nonmagnetic metal layer 130 may be formed of the material which belongs to the group A or the material which belongs to the group B. In the thermoelectric converting thin line 200, an electromotive force may be obtained above and below the thin line 110.

Because the thermoelectric converting thin line 200 is in the form of threads, the thermoelectric converting thin line 200 has flexibility. Accordingly, the thermoelectric converting thin line 200 may be wound around a heating element without forming a gap therebetween, thus power may be generated efficiently. Further, because the thermoelectric converting thin line 200 is in the form of threads, the thermoelectric converting thin line 200 may be handled with ease. Accordingly, by weaving the thermoelectric converting thin lines 200 into a cloth, the thermoelectric converting thin lines 200 may be easily mounted, thus an amount of power may be enhanced. Further, power is generated by the two nonmagnetic metal layers 130 in the thermoelectric converting thin line 200 and hence, the thermoelectric converting thin line 200 may generate a greater an electromotive force layer than generated in the thermoelectric converting thin line 100.

In the thermoelectric converting thin line 200, the two ferromagnetic layers 120 arranged above and below the thin line 110 are separated from each other. This is because it is necessary to make the magnetization of the upper ferromagnetic layer 120 and the magnetization of the lower ferromagnetic layer 120 be directed in a same direction. When the upper ferromagnetic layer 120 and the lower ferromagnetic layer 120 are connected by electrodes 150, 160, the magnetization is formed in a circular shape in the cross section of the thin line 110, thus the direction of the magnetization of the upper ferromagnetic layer 120 and the direction of the magnetization of the lower ferromagnetic layer 120 become opposite to each other.

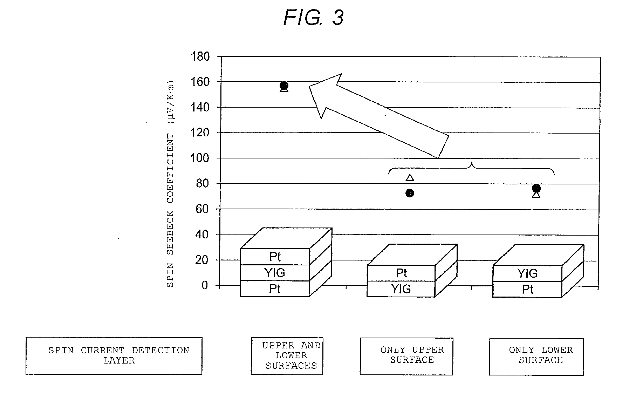

Fig. 3 is a graph illustrating a result of measurement of an electromotive force in a state where a nonmagnetic metal layer (spin current detection layer) is formed on an upper surface of the ferromagnetic layer (spin current generating layer), a nonmagnetic metal layer is formed on a lower surface of the ferromagnetic layer, and a nonmagnetic metal layer is formed on both upper and lower surfaces of the ferromagnetic layer. In the order from a left side to a right side in Fig. 3, a result of an electromotive force of a thermoelectric converting thin line where the nonmagnetic metal layer is formed on both upper and lower surfaces of the ferromagnetic layer, a result of an electromotive force of the thermoelectric converting thin line where the nonmagnetic metal layer is formed on the upper surface of the ferromagnetic layer, and a result of an electromotive force of the thermoelectric converting thin line where the nonmagnetic metal is formed on the lower surface of the ferromagnetic layer are illustrated.

A Y₃Fe₅O₁₂ layer having a thickness of 2mm is used as the ferromagnetic layer. A Pt layer having a thickness of 10nm is used as the nonmagnetic metal layer. An electromotive force is measured using a following method. A temperature difference between the upper surface and the lower surface of the thermoelectric converting thin line is set to 0K, 5K, 10K respectively by cooling the upper surface of the thermoelectric converting thin line and by heating the lower surface of the thermoelectric converting thin line. Two electrodes are mounted on the nonmagnetic metal layer. Then, an electromotive force V (µV) of the nonmagnetic metal layer is measured. V/T (µV/K) is estimated based on temperature dependency, and a spin Seebeck coefficient (µV/K·m) per unit length is measured by dividing V/T (µV/K) by 2.8 mm which is a distance between the electrodes. The spin Seebeck coefficient is a parameter indicating an electromotive force (µV) per 1 m, 1 K.

With respect to a case where the nonmagnetic metal layer is formed on the upper surface or the lower surface of the ferromagnetic layer, an electromotive force is 80 µV/K·m when the nonmagnetic metal layer is formed on the upper surface of the ferromagnetic layer, and an electromotive force is 75 µV/K·m when the nonmagnetic metal layer is formed on the lower surface of the ferromagnetic layer. On the other hand, an electromotive force is 155 µV/K·m when the nonmagnetic metal layer is formed on both upper and lower surfaces of the ferromagnetic layer. It is found out from the results that when the nonmagnetic metal layer is formed on both upper and lower surfaces of the ferromagnetic layer, an electromotive force increases, as compared to a case where the nonmagnetic metal layer is formed on either one of the upper surface or the lower surface of the ferromagnetic layer.

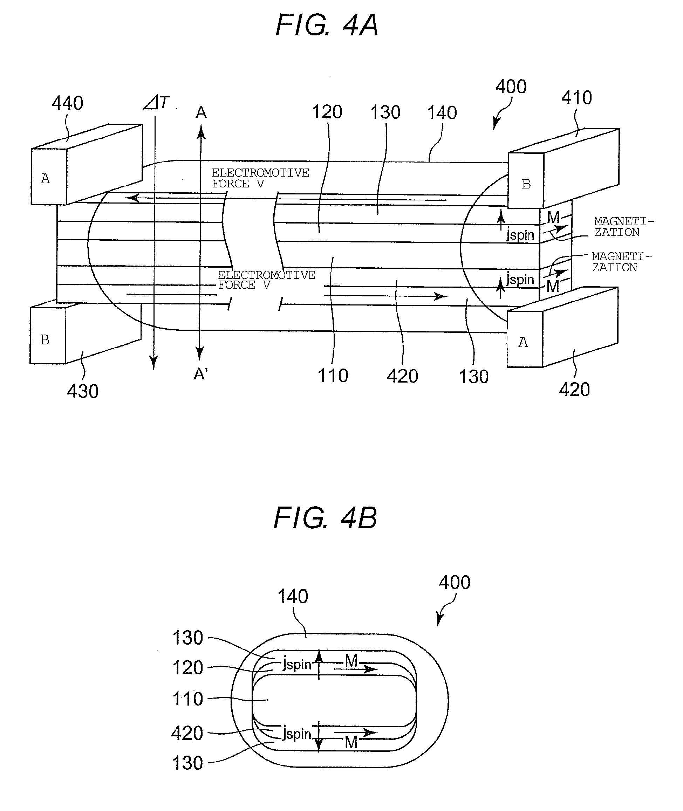

Fig. 4A and Fig. 4B are views illustrating a thermoelectric converting thin line 400 according to a third embodiment. Fig. 4A is a perspective view of the thermoelectric converting thin line 400. Fig. 4B is a cross-sectional view taken along a line A-A' in the perspective view of the thermoelectric converting thin line 400.

In the thermoelectric converting thin line 400, the magnetization of a ferromagnetic layer 120 and the magnetization of a ferromagnetic layer 420 are antiparallel to each other. Further, the thermoelectric converting thin line 400 includes two nonmagnetic metal layers 130. The nonmagnetic metal layers 130 may be formed of either one of the material which belongs to the group A or the material which belongs to the group B described in the first embodiment. In this case, four electrodes 410, 420, 430, 440 are used as electrodes. The electrodes 410, 440 are connected to both ends of the first nonmagnetic metal layer 130 respectively, and the electrodes 420, 430 are connected to the both ends of the second nonmagnetic metal layer 130 respectively.

A material for forming the electrodes 410, 420, 430, 440 is the same as the material for forming the electrodes 150, 160.

The magnetization of the ferromagnetic layer 120 and the magnetization of the ferromagnetic layer 420 are antiparallel to each other and hence, the magnetization is easily stabilized by magneto-static coupling.

In the thermoelectric converting thin line 400, a direction of an electromotive force generated in the first nonmagnetic metal layer 130 and a direction of an electromotive force generated in the second nonmagnetic metal layer 130 are opposite to each other. This is because the magnetization of the ferromagnetic layer 120 and the magnetization of the ferromagnetic layer 420 are antiparallel to each other. In order to prevent short-circuiting between an electromotive force generated in the first nonmagnetic metal layer 130 and an electromotive force generated in the second nonmagnetic metal layer 130, the number of electrodes for taking out an electromotive force is four as in Fig. 4.

Because the thermoelectric converting thin line 400 is in the form of threads, the thermoelectric converting thin line 400 has flexibility. Accordingly, the thermoelectric converting thin line 400 may be wound around a heating element without forming a gap therebetween, thus power may be generated efficiently. Further, because the thermoelectric converting thin line 400 is in the form of threads, the thermoelectric converting thin line 400 may be handled with ease. Accordingly, by weaving the thermoelectric converting thin lines 400 into a cloth, the thermoelectric converting thin lines 400 may be easily mounted, thus an amount of power may be enhanced.

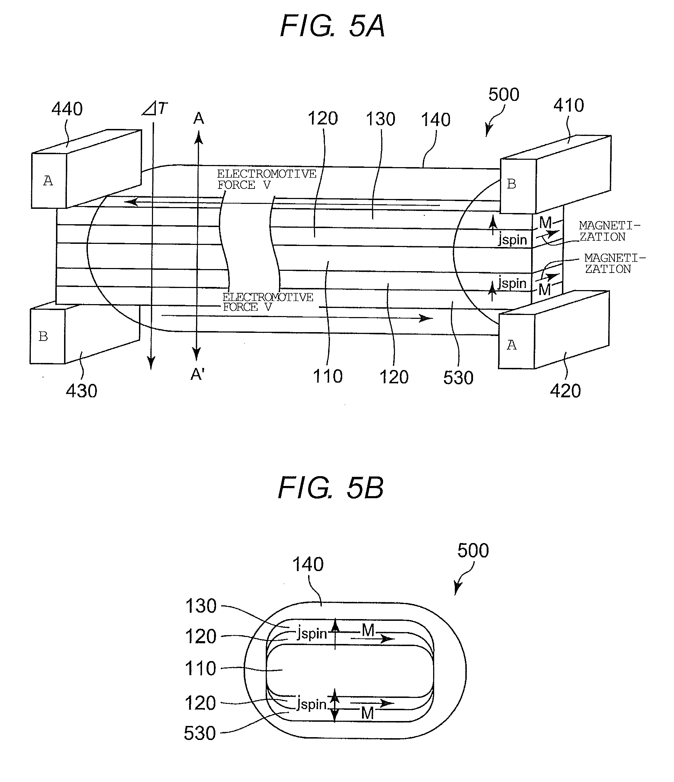

Fig. 5A and Fig. 5B are views illustrating a thermoelectric converting thin line 500 according to a fourth embodiment. Fig. 5A is a perspective view of the thermoelectric converting thin line 500. Fig. 5B is a cross-sectional view taken along a line A-A' in the perspective view of the thermoelectric converting thin line 500.

In the thermoelectric converting thin line 500, the magnetizations of the two ferromagnetic layers 120 are parallel to each other, and are directed in the same direction. The thermoelectric converting thin line 500 includes nonmagnetic metal layers 130, 530. The material which belongs to the group A in the first embodiment is used for forming the nonmagnetic metal layer 130, and the material which belongs to the group B in the first embodiment is used for forming the nonmagnetic metal layer 530. On the other hand, the material which belongs to the group B may be used for forming the nonmagnetic metal layer 130, and the material which belongs to the group A may be used for forming the nonmagnetic metal layer 530.

In the thermoelectric converting thin line 500, a direction of an electromotive force generated in the nonmagnetic metal layer 130 and a direction of an electromotive force generated in the nonmagnetic metal layer 530 are opposite to each other. This is because the material for forming the nonmagnetic metal layer 130 differs from the material for forming the nonmagnetic metal layer 530.

Because the thermoelectric converting thin line 500 is in the form of threads, the thermoelectric converting thin line 500 has flexibility. Accordingly, the thermoelectric converting thin line 500 may be wound around a heating element without forming a gap therebetween, thus power may be generated efficiently. Further, because the thermoelectric converting thin line 500 is in the form of threads, the thermoelectric converting thin line 500 may be handled with ease. Accordingly, by weaving the thermoelectric converting thin lines 500 into a cloth, the thermoelectric converting thin lines 500 may be easily mounted, thus an amount of power may be enhanced.

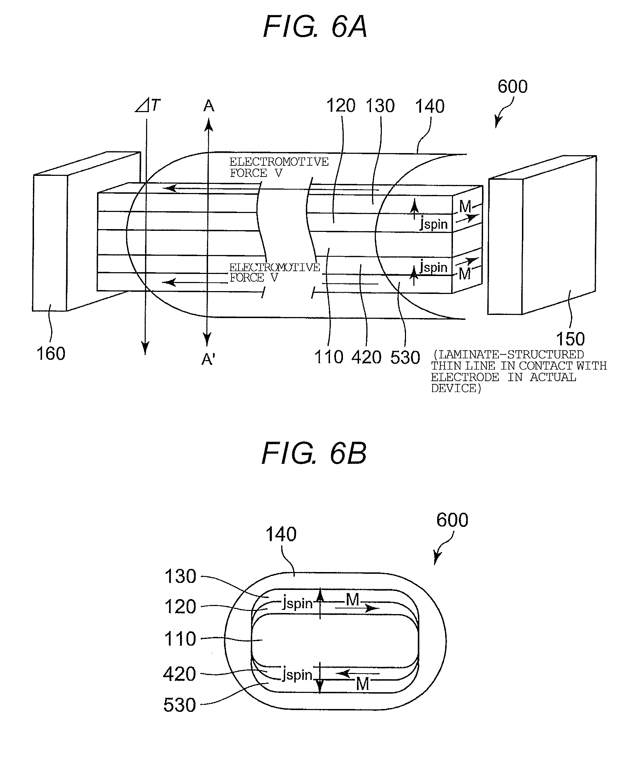

Fig. 6A and Fig. 6B are views illustrating a thermoelectric converting thin line 600 according to a fifth embodiment. Fig. 6A is a perspective view of the thermoelectric converting thin line 600. Fig. 6B is a cross-sectional view taken along a line A-A' in the perspective view of the thermoelectric converting thin line 600.

In the thermoelectric converting thin line 600, magnetization of a ferromagnetic layer 120 and magnetization of a ferromagnetic layer 420 are antiparallel to each other. The thermoelectric converting thin line 600 includes nonmagnetic metal layers 130, 530. The material which belongs to the group A in the first embodiment is used for forming the nonmagnetic metal layer 130, and the material which belongs to the group B in the first embodiment is used for forming the nonmagnetic metal layer 530. On the other hand, the material which belongs to the group B may be used for forming the nonmagnetic metal layer 130, and the material which belongs to the group A may be used for forming the nonmagnetic metal layer 530.

In the thermoelectric converting thin line 600, an electromotive force generated in the nonmagnetic metal layer 130 and an electromotive force generated in the nonmagnetic metal layer 530 are directed in the same direction.

In the thermoelectric converting thin line 600, an electromotive force generated in the nonmagnetic metal layer 130 and an electromotive force generated in the nonmagnetic metal layer 530 are directed in the same direction and hence, unlike the thermoelectric converting thin lines 400, 500, it is sufficient to respectively mount electrodes 150, 160 on both ends of the thermoelectric converting thin line 600.

Because the thermoelectric converting thin line 600 is in the form of threads, the thermoelectric converting thin line 600 has flexibility. Accordingly, the thermoelectric converting thin line 600 may be wound around a heating element without forming a gap therebetween, thus power may be generated efficiently. Further, because the thermoelectric converting thin line 600 is in the form of threads, the thermoelectric converting thin line 600 may be handled with ease. Accordingly, by weaving the thermoelectric converting thin lines 600 into a cloth, the thermoelectric converting thin lines 600 may be easily mounted, thus an amount of power may be enhanced.

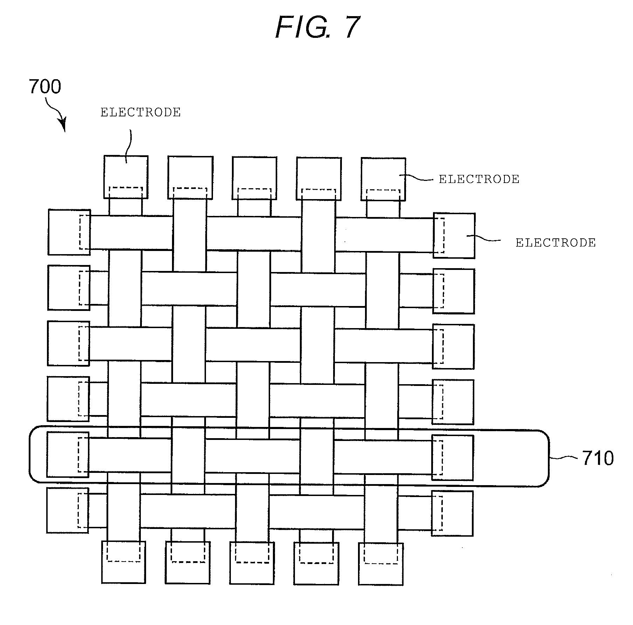

Fig. 7 is a view illustrating a thermoelectric converting cloth 700. The thermoelectric converting cloth 700 is formed by weaving thermoelectric converting thin lines 710 by plain weaving. The thermoelectric converting thin lines 710 extend in a column direction (warp direction) as well as in a row direction (weft direction). It is assumed that the thermoelectric converting thin line 710 is the thermoelectric converting thin line 100, the thermoelectric converting thin line 200 or the thermoelectric converting thin line 600. A portion in Fig. 7 surrounded by a line indicates the thermoelectric converting thin line 710. At a position where the thermoelectric converting thin lines 710 intersect with each other, an amount of power generated by the thermoelectric conversion is twice as large as an amount of power generated at a position where only a single thin line 710 is arranged. As illustrated in Fig. 7, electrodes are connected to both ends of each thermoelectric converting thin line 710. It is sufficient that the electrodes are connected to at least a nonmagnetic metal layer (spin current detection layer) of the thermoelectric converting thin line 710. The electrode may have any shape.

Although the description has been made with respect to a constitution where the whole thermoelectric converting cloth 700 is formed of the thermoelectric converting thin lines 710, a portion of the thermoelectric converting cloth 700 may be replaced with other fabric. By replacing the portion of the thermoelectric converting cloth 700 with other fabric, a user may use the thermoelectric converting cloth 700 without feeling discomfort.

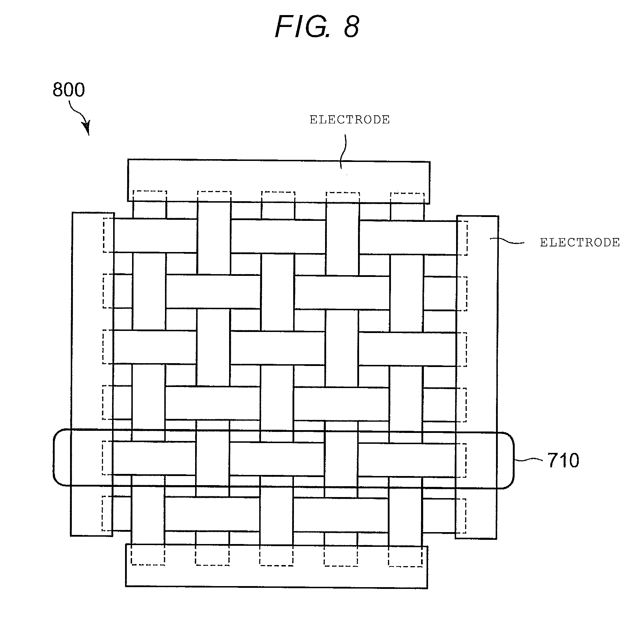

Fig. 8 is a view illustrating a thermoelectric converting cloth 800. The thermoelectric converting cloth 800 is formed by weaving the thermoelectric converting thin lines 710 by plain weaving. The thermoelectric converting cloth 800 differs from the thermoelectric converting cloth 700 in a point that one electrode is common to all thermoelectric converting thin lines 710 extending in the column direction and another electrode is common to all thermoelectric converting thin lines 710 extending in the row direction. The thermoelectric converting thin lines 710 are connected in parallel to each other in the column direction and the thermoelectric converting thin lines 710 are connected in parallel to each other in the row direction. Although the description has been made with respect to a constitution where the whole thermoelectric converting cloth 800 is formed of the thermoelectric converting thin lines 710, a portion of the thermoelectric converting cloth 800 may be replaced with other fabric. By replacing the portion of the thermoelectric converting cloth 800 with other fabric, a user may use the thermoelectric converting cloth 800 without feeling discomfort.

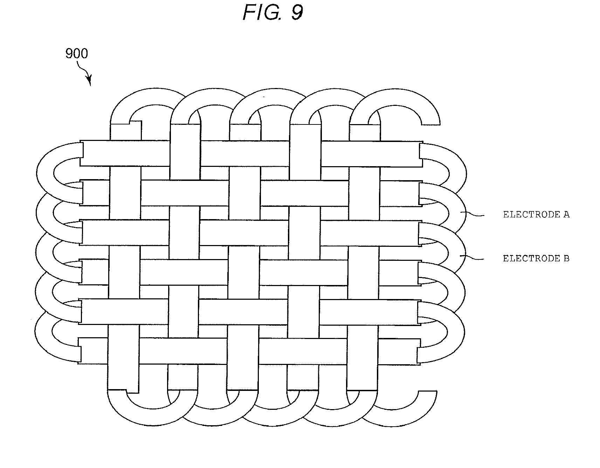

Fig. 9 is a view illustrating a thermoelectric converting cloth 900. The thermoelectric converting cloth 900 is formed by weaving thermoelectric converting thin lines 910 by plain weaving.

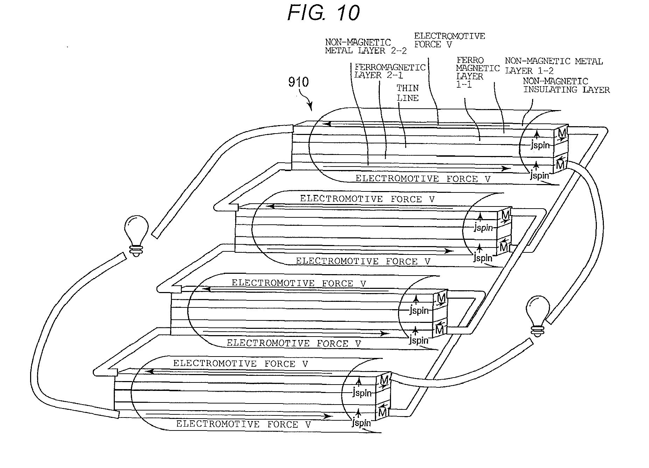

Fig. 10 is a view illustrating a constitution of the thermoelectric converting cloth 900 shown in Fig. 9. In the thermoelectric converting thin line 910, a direction of an electromotive force of a nonmagnetic metal layer 1-2 (spin current detection layer 1) and a direction of an electromotive force of a nonmagnetic metal layer 2-2 (spin current detection layer 2) are opposite to each other. It is assumed that the thermoelectric converting thin line 910 is formed of the thermoelectric converting thin line 400 or the thermoelectric converting thin line 500. An electrode connected to a nonmagnetic metal layer 1-2 of one thermoelectric converting thin line 910 is connected to a nonmagnetic metal layer 2-2 of another thermoelectric converting thin line 910 arranged adjacent to the one thermoelectric converting thin line 910. In this manner, by alternately connecting the nonmagnetic metal layer 1-2 of the one thermoelectric converting thin line 910 and the nonmagnetic metal layer 2-2 of the another thermoelectric converting thin line 910 arranged adjacent to the one thermoelectric converting thin line 910, the thermoelectric converting thin lines 910 which are arranged adjacent to each other may be connected in series.

A method of manufacturing a thermoelectric converting thin line is described.

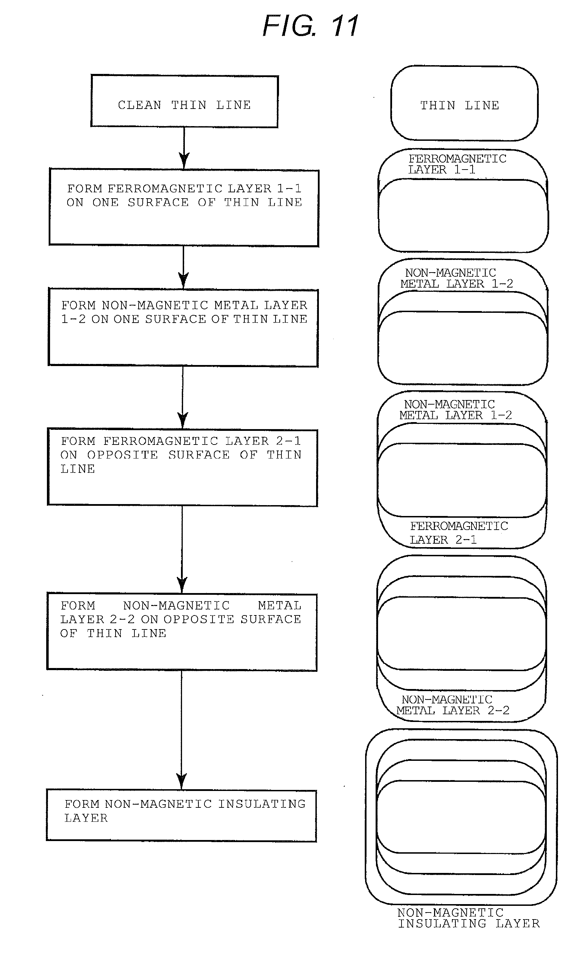

Fig. 11 is a flowchart for illustrating a method of manufacturing a thermoelectric converting thin line.

A flat substrate which constitutes a thin line is prepared. An aspect ratio, of a flat substrate, which is a ratio between a size of the flat substrate in a short axis direction and a size of the flat substrate in a long axis direction is set to approximately 1 to 2 in order to prevent twisting of the thin line during weaving the thin lines into a cloth. The flat substrate is cleaned, and a ferromagnetic layer 1-1 (spin current generating layer) is formed on the flat substrate. A nonmagnetic metal layer 1-2 (spin current detection layer) is formed on the ferromagnetic layer 1-1.

Next, a ferromagnetic layer 2-1 (spin current generating layer), and a nonmagnetic metal layer 2-2 (spin current detection layer) are formed on a back surface of the flat substrate in this order. Lastly, the whole laminate-structured thin line is covered with a nonmagnetic insulating layer by plating. In place of forming the layers on the substrate using a film, the layers may be formed on the substrate by coating, sputtering, or vapor deposition. Although the description has been made on a premise that the films are formed on both surfaces of the substrate, the films may be formed only on one surface of the substrate.

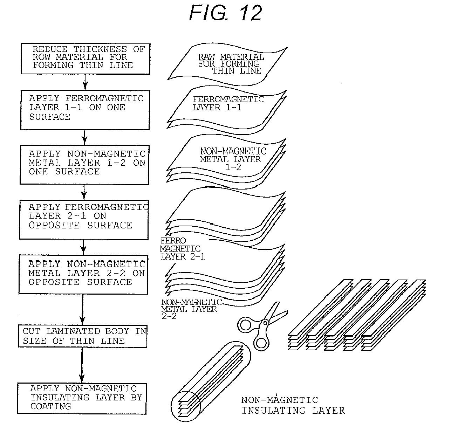

Fig. 12 is a view for illustrating another method of manufacturing a thermoelectric converting thin line.

A flat substrate which constitutes a thin line is prepared. The flat substrate is cleaned, and a ferromagnetic layer 1-1 (spin current generating layer) is formed on the flat substrate. A nonmagnetic metal layer 1-2 (spin current detection layer) is formed on the ferromagnetic layer 1-1.

Next, a ferromagnetic layer 2-1 (spin current generating layer) and a nonmagnetic metal layer 2-2 (spin current detection layer) are formed on a back surface of the flat substrate in this order. A laminated body is cut into thin lines. An aspect ratio, of a cross section of a laminated body, which is a ratio between a size of the laminated body in a short axis direction and a size of the laminated body in a long axis direction is set to approximately 1 to 2 in order to prevent twisting of the thin line during weaving the thin line into a cloth. Lastly, the whole laminated body is covered with a nonmagnetic insulating layer by plating. In place of forming the layers on the substrate using a film, the layers may be formed on the substrate by coating, sputtering or vapor deposition. Although the description has been made on a premise that the films are formed on both surfaces of the substrate, the film may be formed only on one surface of the substrate.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A thermoelectric converting thin line, comprising:
a thin line extending in one direction;
a first ferromagnetic layer formed on a side of the thin line and having a magnetization fixed in a plane in a direction intersecting with a direction along which the thin line extends; and
a first nonmagnetic metal layer formed on the first ferromagnetic layer.

2. The thermoelectric converting thin line of claim 1, further comprising:
a second ferromagnetic layer formed on a side of the thin line opposite to the side on which the first ferromagnetic layer is formed so that the thin line is sandwiched between the first ferromagnetic layer and the second ferromagnetic layer, the second ferromagnetic layer having a magnetization fixed in a same direction as the magnetization of the first ferromagnetic layer; and
a second nonmagnetic metal layer formed on the second ferromagnetic layer.

3. The thermoelectric converting thin line of claim 1, further comprising:
a second ferromagnetic layer formed on a side of the thin line opposite to the side on which the first ferromagnetic layer is formed so that the thin line is sandwiched between the first ferromagnetic layer and the second ferromagnetic layer, the second ferromagnetic layer having a magnetization fixed in an opposite direction to the magnetization of the first ferromagnetic layer; and
a second nonmagnetic metal layer formed on the second ferromagnetic layer.

4. The thin line of claim 2, wherein the first nonmagnetic metal layer comprises at least one of elements selected from Pt, Au, and Ir and the second nonmagnetic metal layer comprises at least one of elements selected from Ta, W, and Cr.

5. The thin line of claim 3, wherein the first nonmagnetic metal layer comprises at least one of elements selected from Pt, Au, and Ir and the second nonmagnetic metal layer comprises at least one of elements selected from Ta, W, and Cr.

6. The thin line of claim 1, wherein the thin line is Polyimide, polypropylene, nylon, polyester, Parylene (registered trademark), rubber, biaxially stretched polyethylene, 6-naphthalate, or modified polyamide.

7. The thin line of claim 1, wherein the first ferromagnetic layer comprises Fe, Co, Ni, FeCr, FeMn, FeCo, NiFe, CoNi, Ferrite, or Y₃Fe₅O₁₂.

8. The thin line of claim 2, wherein the second ferromagnetic layer comprises Fe, Co, Ni, FeCr, FeMn, FeCo, NiFe, CoNi, Ferrite, or Y₃Fe₅O₁₂.

9. The thin line of claim 1, further comprising a pair of electrodes respectively connected to opposite ends of a laminated thin line structure comprising the thin line, the first ferromagnetic layer, and the first nonmagnetic metal layer.

10. The thin line of claim 2, further comprising a pair of electrodes respectively connected to opposite ends of a laminated thin line structure comprising the thin line, the first ferromagnetic layer, the second ferromagnetic layer, the first nonmagnetic metal layer, and the second nonmagnetic metal layer.

11. The thin line of claim 2, further comprising a first pair of electrodes respectively connected to opposite ends of the first nonmagnetic metal layer and a second pair of electrodes respectively connected to opposite ends of the second nonmagnetic metal layer.

12. A thermoelectric converting cloth, comprising a plurality of the thin lines of any of claims 9 to 11 woven in a row direction and in a column direction.

13. The cloth of the claim 12, wherein the pair of electrodes are formed integrally in each of the column direction and row direction.

14. A thermoelectric converting cloth, comprising a plurality of the thin lines of claim 10 woven in a row direction and in a column direction, and the electrode connected to the first nonmagnetic metal layer of the thin line and the electrode connected to the second nonmagnetic metal layer of the other thin line are connected.

15. A thermoelectric converting cloth, comprising a plurality of the thin lines of claim 11 woven in a row direction and in a column direction, a first electrode, of the first pair of electrodes, at one end of a first one of the plurality of the thin lines being connected to a first electrode, of the second pair of electrodes, at one end of a second one of the plurality of the thin lines adjacent to the first one of the plurality of thin lines.
